(19) Europäisches Patentamt
European Patent Office
Office européen des brevets

(11) EP 0 855 038 B1

(12) **FASCICULE DE BREVET EUROPEEN**

(45) Date de publication et mention
de la délivrance du brevet:
**27.08.2003 Bulletin 2003/35**

(21) Numéro de dépôt: **96916208.0**

(22) Date de dépôt: **15.05.1996**

(51) Int Cl.⁷: $G01R\ 31/28$

(86) Numéro de dépôt international:
**PCT/FR96/00736**

(87) Numéro de publication internationale:
**WO 97/043659 (20.11.1997 Gazette 1997/50)**

(54) **Diagnostic de réseaux de composants, avec modélisation par bandes**

Diagnose von Netzen von Bauelementen unter Verwendung einer Bänder-Modellierung

Component network diagnosis, using modelling by bands

(84) Etats contractants désignés:
**BE CH DE ES FR GB IT LI NL**

(43) Date de publication de la demande:
**29.07.1998 Bulletin 1998/31**

(73) Titulaire: **THALES SYSTEMES AEROPORTES S.A.**
**78990 Elancourt (FR)**

(72) Inventeurs:
• **TAILLIBERT, Patrick**
**F-78160 Marly le Roi (FR)**

• **LOIEZ, Etienne**
**F-59000 Lille (FR)**

(74) Mandataire: **Plaçais, Jean-Yves et al**
**Cabinet Netter,**
**36, avenue Hoche**
**75008 Paris (FR)**

(56) Documents cités:
**EP-A- 0 408 425      US-A- 5 046 034**
**US-A- 5 214 653      US-A- 5 327 437**
**US-A- 5 412 802**

**Description**

L'invention concerne le diagnostic automatique de réseaux de composants.

La Demanderesse a déjà proposé un dispositif de diagnostic capable d'opérer sur des signaux analogiques (EP-A-408 425). Il travaille sur la base de modèles fonctionnels. Ceux-ci comprennent des expressions-composant portant sur des grandeurs physiques relatives à un composant, comme la loi d'Ohm ($V = R.I$) ; ils comprennent aussi des expressions-lois représentant des relations générales entre grandeurs physiques, comme la loi des noeuds : la somme algébrique des courants en un noeud est nulle.

Le diagnostic part de grandeurs physiques captées. Celles-ci sont stockées en mémoire sous forme d'échantillons, en correspondance d'une spécification des noeuds et composants du réseau concernés.

Si le dispositif travaille "en aveugle" (sans connaître a priori le schéma du réseau), la spécification des noeuds et composants doit être suffisante pour lui permettre d'apprendre le schéma du réseau au fur et à mesure de l'exploration de celui-ci. Si au contraire le schéma du réseau est connu à l'avance, il suffit de désigner chaque point de mesure dans ce schéma connu.

Pour chaque capture, les échantillons sont rapportés à un intervalle de temps choisi de travail. Le dispositif y recherche des anomalies par rapport aux modèles fonctionnels (expressions-lois et expressions-composants). Ceci est fait pour chaque instant d'échantillonnage dans l'intervalle de temps de travail.

Généralement, les échantillons de grandeurs physiques captées ne se prêtent pas directement à la détection des anomalies. Il faut d'abord calculer des grandeurs physiques estimées, autant que nécessaire pour ne plus avoir d'inconnues. C'est alors qu'une expression non respectée, compte-tenu des incertitudes, permet en principe de localiser le défaut.

Le but est de localiser un composant défectueux dans le réseau concerné, et ce, en un temps minimum.

Il s'est avéré cependant que des difficultés subsistaient, pour certaines applications.

Tout d'abord, le dispositif antérieur fonctionne par "propagation": pour chaque instant d'échantillonnage, il faut, à partir des échantillons mesurés, calculer des grandeurs estimées autant que nécessaire, puis travailler itérativement sur les modèles jusqu'à trouver le composant défaillant. Il est clair que le nombre des opérations, et par conséquent le temps passé, croissent très vite, lorsque la complexité du circuit à analyser augmente.

De plus, pour réaliser les modèles fonctionnels, il faut "encadrer" certaines variables, c'est-à-dire leur fixer un minimum et un maximum. Or, dans certaines situations, les signaux analogiques (tension ou courant) varient très rapidement. Il s'est avéré qu'encadrer leurs dérivées devient alors particulièrement délicat, surtout avec prise en compte d'une incertitude.

Ces difficultés s'aggravent du fait qu'il y a lieu en outre de considérer non pas des valeurs brutes, mais des fourchettes d'incertitude, dans la plupart des cas.

Elles s'aggravent également chaque fois qu'il est nécessaire de faire intervenir dans les modèles non seulement les grandeurs elles-mêmes, mais aussi leurs dérivées premières (ou d'ordre supérieur), comme c'est souvent le cas. Il est souvent difficile d'encadrer de telles dérivées par des fourchettes d'incertitude, en présence de variations rapides des grandeurs de base elles-mêmes.

La présente invention a notamment pour but d'apporter une solution à ces problèmes.

Le dispositif proposé est du type connu comportant:

- une mémoire d'entrée pour recevoir des blocs de mesures (dans l'art antérieur, des paquets d'échantillons numériques), dont chacun représente des mesures d'une grandeur physique effectuées en un emplacement connu du réseau,
- une mémoire de base, pour stocker la définition de modèles fonctionnels relatifs au réseau, et
- des moyens de traitement capables de déterminer si un modèle fonctionnel est vérifié ou non par un ou des blocs de mesures, afin d'identifier un éventuel défaut de l'un au moins des composants du réseau.

L'invention fait tout d'abord usage d'une représentation spécifique des blocs de mesure, sous la forme de n-uplets. Un n-uplet représente l'évolution temporelle d'une variable, à partir d'un jeu de nombres, qui définissent un intervalle de temps, et une enveloppe de la variable sur cet intervalle de temps, c.-à-d. un domaine en bande encadrant l'évolution de la variable sur cet intervalle de temps. Le dispositif comporte en outre des moyens de calcul sur n-uplets, moyens qui peuvent être considérés comme inclus aux moyens de traitement, ou comme des outils séparés de ceux-ci.

Le dispositif de l'invention comporte aussi des moyens de test propres à recevoir un ou des n-uplets (Nf,Ng), et à fournir une sortie relative à la vérification d'une expression standard par ces n-uplets. On verra que ces moyens de test peuvent opérer sans examiner exhaustivement le contenu des enveloppes que représentent ce ou ces n-uplets (Nf,Ng).

Dans la mémoire d'entrée, chaque bloc de mesures est stocké sous la forme d'au moins un n-uplet initial.

Dans la mémoire de base, la définition d'un modèle fonctionnel comprend une liste de composants ($L_v$), et

la désignation (Df, Dg) d'au moins une fonction particulière des grandeurs mesurables ($L_p$). Associée à l'expression standard des moyens de test, cette fonction particulière définit l'équation du modèle.

Enfin, les moyens de traitement comprennent:

- des moyens de gestion, capables, répétitivement,

  . de coopérer avec la mémoire de base, pour faire correspondre des n-uplets initiaux disponibles, et au moins un modèle applicable aux grandeurs mesurables que représentent ces n-uplets,
  . de faire appel aux calculs sur n-uplets, avec la désignation de fonction (Df,Dg) du modèle, et ces n-uplets, pour obtenir au moins un n-uplet résultat (Nf,Ng),
  . d'appliquer le n-uplet résultat (Nf, Ng) aux moyens de test, et
  . d'associer la sortie des moyens de test à la liste de composants ($L_v$) du modèle,

- ainsi qu'une logique de décision, capable d'analyser différentes sorties des moyens de test, en vue de déterminer un ou des composants défectueux.

Très avantageusement, les modèles portent uniquement sur des grandeurs directement mesurables; de même, chaque grandeur mesurable intervient au plus une fois dans chaque désignation de fonction (Df,Dg) d'un modèle.

De préférence, pour les n-uplets initiaux, l'enveloppe est délimitée comme un trapèze, de bases verticales en graphe amplitude/temps. On verra que cela correspond à un n-uplet d'ordre 1.

Le dispositif peut encore comporter des moyens pour recevoir ou construire une carte d'un réseau à diagnostiquer, et un générateur de relations-modèles à partir de cette carte et de lois physiques sur les composants du réseau.

Dans le mode de réalisation actuellement préféré, les moyens de test et les désignations de fonctions définissent ensemble une structure standard d'équations différentielles, telle que f() + g'() = 0. Il en résulte des conséquences sur lesquelles on reviendra plus loin.

D'autres caractéristiques et avantages de l'invention apparaîtront à l'examen de la description détaillée ci après, et des dessins sur lesquels:

- la figure 1 est un schéma général du dispositif selon l'invention ;

- les figures 2, 3 et 4A à 4C sont des graphes amplitude/temps illustrant la définition et le rôle des n-uplets ;

- les figures 5 et 6 illustrent deux exemples de circuits électroniques simples ;

- la figure 7 est un graphe amplitude/temps illustrant une suite de n-uplets ;

- les figures 8A et 8B sont deux autres graphes amplitude/temps relatifs aux n-uplets ;

- la figure 9 est un schéma plus détaillé de l'unité de test 66 ; et

- la figure 10 est un autre schéma relatif à l'unité de test 66.

Les dessins annexés sont pour l'essentiel de caractère certain. Ils font donc partie intégrante de la présente description, et pourront contribuer à la définition de l'invention.

L'invention sera décrite ci-après à titre d'exemple dans le cadre d'un réseau de composants électroniques. Elle peut trouver de nombreuses autres applications.

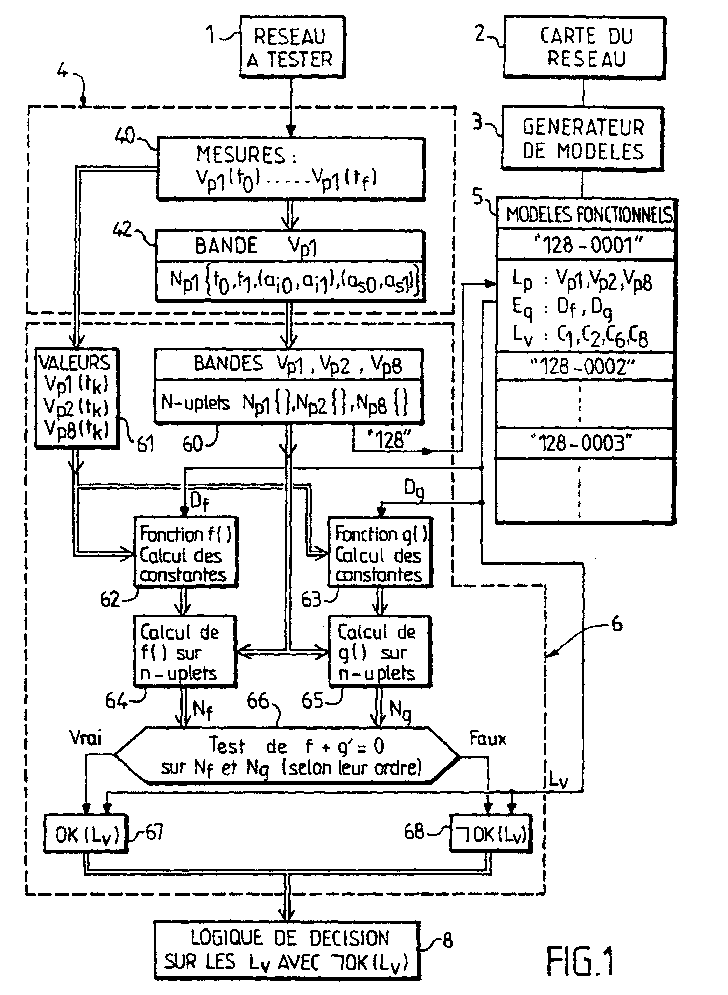

Sur la figure 1, la référence 1 désigne un réseau de composants électroniques interconnectés à tester. De manière connue, on dispose en 2 d'une représentation informatique ou "carte" de ce réseau.

Du fait que les intensités de courant sont peu souvent mesurées directement, on ne parlera ci-après que de tensions électriques. On appellera donc "grandeur mesurable" une tension électrique directement mesurable en un point du réseau. On considère également que toutes les mesures de tension se font en référence à un même point commun, tel qu'une masse. S'il en était autrement, il faudrait associer un couple de points à chaque mesure de tension.

En 4, le dispositif comporte une mémoire d'entrée 40, pour recevoir des blocs d'échantillons consécutifs d'une tension électrique $Vp_1$ mesurée en fonction du temps (de $t_0$ à $t_f$). A chaque bloc d'échantillons est associée la désignation de l'emplacement ou point de mesure $p_1$ concerné. Et la mesure est entachée d'une incertitude (connue, non représentée).

L'invention fait tout d'abord usage d'une représentation particulière des mesures, par bandes, qui seront stockées dans la mémoire 42.

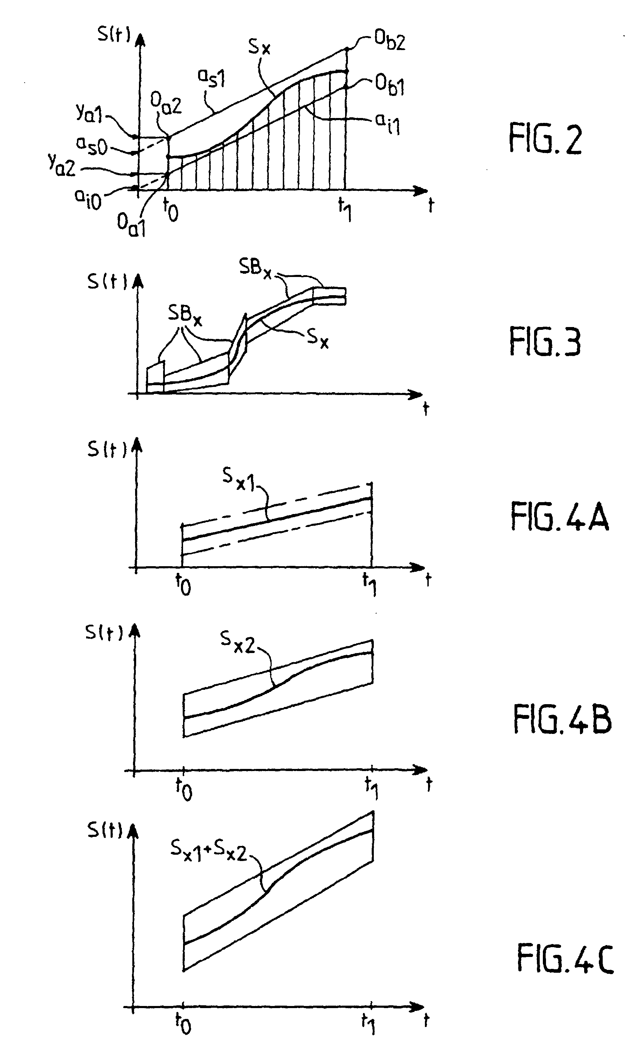

On considère une mesure quelconque $S_x(t)$. Il est toujours possible de représenter cette mesure, compte tenu de son incertitude, par une enveloppe (figure 2, où les barres verticales rappellent que la mesure est constituée d'échantillons).

La Demanderesse propose que l'on définisse cette enveloppe (figure 2) par l'intervalle de temps concerné $[t_0, t_1]$, et, par une représentation convenable des droites support des segments $O_{a1} O_{b1}$ et $O_{a2} O_{b2}$. L'enveloppe est ainsi délimitée par le trapèze dont les bases parallèles sont les segments verticaux $O_{a1} O_{a2}$ et $O_{b1} O_{b2}$, et les autres côtés sont les droites $O_{a1} O_{b1}$ et $O_{a2} O_{b2}$.

De façon imagée, ces enveloppes sont appelées "bandes". En effet, à un n-uplet de valeurs, on va faire correspondre un domaine en bande circonscrit à l'évolution de la variable concerné sur une durée définie.

La représentation des droites support des segments $O_{a1} O_{b1}$ et $O_{a2} O_{b2}$ pourrait se faire par les ordonnées $(y_{a1}, y_{a2})$ aux points $t_0$ et $t_1$, ainsi que les pentes $(a_{i1}, a_{s1})$ de ces deux droites, ou encore par $y_{a1}, y_{a2}, y_{b1}, y_{b2}$. On préfère actuellement utiliser les ordonnées à l'origine $(a_{i0}, a_{s0})$ et les pentes $(a_{i1}, a_{s1})$ des droites inférieure (indice i) $O_{a1} O_{b1}$ et supérieure (indice s) $O_{a2} O_{b2}$.

L'enveloppe du signal $S_x$ est complètement définie par les grandeurs $(t_0, t_1, (a_{i0}, a_{i1}), (a_{s0}, a_{s1}))$, qui forment ensemble un n-uplet $N_x$ (ou un vecteur au sens mathématique, mais non géométrique, du mot).

En fait, l'enveloppe étant délimitée par des segments de droites, une mesure $S_x(t)$ devra souvent être encadrée par une suite d'enveloppes successives (figure 3), dont chacune encadre de près la mesure, compte-tenu de son incertitude.

La construction d'un n-uplet $N_x$ pour un signal $S_x$ donné peut se faire par des moyens connus. Elle est simple si $O_{a1} O_{b1}$ et $O_{a2} O_{b2}$ sont des segments de droites: par exemple, on peut prendre la droite de régression associée au signal $S_x$, et obtenir les deux segments, respectivement en retranchant et ajoutant à cette droite de régression une quantité suffisante pour englober tous les échantillons de $S_x$.

La Demanderesse a observé que l'on peut effectuer des calculs directement sur ces n-uplets.

Tout d'abord, il est aisé de subdiviser le n-uplet $N_x$ d'un signal $S_x$ en plusieurs n-uplets $N_{x1}$ et $N_{x2}$ correspondant à des sous-ensembles de l'intervalle de temps $[t_0, t_1]$ du n-uplet $N_x$. Il suffit de modifier $t_0$ et $t_1$ dans les n-uplets résultats (relations I annexées).

De même, à partir de deux n-uplets (ou plus) relatifs à des intervalles de temps consécutifs (une "suite de n-uplets"), on peut aussi créer un n-uplet représentant l'ensemble des valeurs d'une grandeur, sur l'intervalle de temps global.

A partir de mesures relatives à des intervalles de temps qui se recoupent, mais ne se confondent pas, on peut donc construire des n-uplets qui sont tous relatifs à un même intervalle de temps, ce que l'on appellera n-uplets "synchrones".

Incidemment, on observera que, pour un groupe de n-uplets synchrones, un changement de variable permet de faire $t_0 = 0$. Ensuite, pour un signal $S_y$ égal à la somme de signaux $S_{x1}$ et $S_{x2}$, on peut calculer directement le n-uplet $N_y$, à partir des n-uplets $N_{x1}$ et $N_{x2}$ (figures 4A à 4C et relations II annexées). On peut faire de même pour la multiplication de signaux (non représentée).

Enfin, il est possible de déterminer un encadrement de l'intégrale du signal $S_x$ à partir de son n-uplet $N_x$. Cette intégrale est comprise entre celles des courbes inférieure $O_{a1} O_{b1}$ et supérieure $O_{a2} O_{b2}$ de l'enveloppe. Ces intégrales se calculent aisément, comme on le verra plus loin dans le cas général.

Si les deux segments de droite sont horizontaux et parallèles, la bande devient d'ordre "zéro". Et le n-uplet associé d'ordre "zéro", peut être défini seulement par quatre paramètres $\{t_0, t_1, (b_{i0}), (b_{s0})\}$. On distinguera ce n-uplet d'ordre zéro de l'intervalle de nombre réels $[b_{i0}, b_{s0}]$, qui est défini indépendamment du temps.

Une bande délimitée par des segments de droites de pente non nulle est d'ordre 1. Le n-uplet correspondant est également d'ordre 1.

On sait également définir les segments $O_{a1} O_{b1}$ et $O_{a2} O_{b2}$ sur des courbes polynomiales d'ordre p (supérieur à 1, qui correspond à la droite). On aura alors une bande et un n-uplet d'ordre p, défini par les expressions (III) annexées. Un tel n-uplet d'ordre p possède $2.(p+2)$ paramètres (intervalle de temps compris). Les courbes polynomiales inférieure (coefficients $a_i$) et supérieure (coefficients $a_s$), encadrent la grandeur $x(t)$ sur tout l'intervalle de temps $[t_0, t_1]$.

La relation (IV) définit l'addition de deux n-uplets synchrones d'ordre p.

La relation (V) définit le n-uplet associé à l'intégrale d'un n-uplet, entre un instant origine $\Theta_0$ et l'instant t (compris entre $t_0$ et $t_1$). On notera que le résultat se simplifie considérablement si $\Theta_0 = 0$ (relation VI).

Il est également possible de définir le produit d'un n-uplet d'ordre p par un nombre réel $b_{i0}$.

On considère tout d'abord le cas d'un n-uplet d'ordre 1, pour lequel l'enveloppe que représente le n-uplet d'ordre 1 est entièrement positive ("n-uplet entièrement positif").

Le produit d'un tel n-uplet d'ordre 1 par un nombre réel positif $b_{i0}$ est défini par la relation (VII). Si $b_{i0}$ est un réel négatif, on intervertit les indices i et s dans le résultat.

On peut traiter de manière analogue, en tenant compte des règles sur le signe d'un produit et d'une inégalité ("<" ou ">"), les cas où:

- le n-uplet est entièrement négatif,
- sur tout l'intervalle de temps $[t_0,t_1]$ du n-uplet, l'enveloppe contient le zéro ("le n-uplet contient zéro").

On qualifie ainsi de monotone un n-uplet qui est entièrement positif, ou bien entièrement négatif, ou bien contient le zéro. Un n-uplet quelconque est décomposable en une suite de n-uplets monotones, auxquels s'appliquent les règles de multiplication ici définies.

Il est également possible de définir le produit d'un n-uplet d'ordre 1 par un intervalle $[b_{i0},b_{s0}]$.

Si $b_{i0}$ et $b_{s0}$ sont positifs, et si le n-uplet est entièrement positif, le produit est défini par la relation (VII): on multiplie les valeurs inférieures (indice i) entre elles, et les valeurs supérieures (indice s) entre elles.

On en déduit comme précédemment ce qui se passe si $b_{i0}$ et $b_{s0}$ sont négatifs et/ou dans les autres cas de n-uplets monotones, compte tenu des règles sur le signe des produits et des inégalités.

On sait aussi définir de manière semblable le produit d'un n-uplet entièrement positif ou entièrement négatif par un intervalle qui contient le zéro, toujours compte tenu des règles sur le signe des produits et des inégalités.

Reste le cas du produit d'un n-uplet qui contient le zéro par un intervalle $[b_{i0},b_{s0}]$ qui contient le zéro. En ce cas, on compare, pour tout t sur l'intervalle de temps $[t_0,t_1]$ :

- $b_{i0} (a_{i0} + a_{i1} t)$ à $b_{s0} (a_{s0} + a_{s1} t)$
- $b_{s0} (a_{i0} + a_{i1} t)$ à $b_{i0} (a_{s0} + a_{s1} t)$
  Si les deux comparaisons conservent le même signe, on peut calculer le n-uplet résultat, comme précédemment, compte tenu des règles sur le signe des produits et des inégalités.

Sinon, il faut découper le n-uplet opérande en plusieurs n-uplets vérifiant la propriété ci-dessus. Le résultat est alors une suite de n-uplets.

On définit de même le produit d'une bande (n-uplet) d'ordre p par un intervalle. Ce produit correspond à un découpage de cette bande en une suite de bandes si soit l'intervalle, soit la bande contiennent le zéro. Ainsi, la bande unique de départ est transformée en une suite de 1 à 5 bandes. Le mécanisme de découpage fait intervenir la résolution d'une équation polynomiale de degré égal à celui de la bande. La résolution sera analytique jusqu'au degré 4 et ensuite numérique, par des méthodes itératives du genre Newton ou semblables.

Bien qu'un intervalle et un n-uplet d'ordre zéro soient différents, le produit d'un n-uplet d'ordre p par un n-uplet d'ordre zéro, de la forme

$$\{t_0,t_1,(b_{i0}),(b_{s0})\}$$

obéit aux mêmes règles que le produit d'un n-uplet d'ordre p par un intervalle.

Plus généralement encore, on peut définir le produit d'un n-uplet (ou bande) d'ordre p par un n-uplet d'ordre q. Il fournit une bande dont l'ordre est (p+q). De plus, un découpage en une suite de bandes est introduit dès que l'une ou l'autre des bandes opérandes contient le zéro. La résolution s'effectue selon les mêmes principes que précédemment.

En bref, la Demanderesse a pu définir notamment les opérations ou relations suivantes, sur des n-uplets synchrones:

- égalité de n-uplets,
- addition de deux n-uplets (ou plus),
- multiplication d'un n-uplet par un scalaire réel (une constante physique ou mathématique),
- multiplication d'un n-uplet d'ordre quelconque par un intervalle (la valeur d'une résistance, par exemple, avec son incertitude),
- multiplication de deux n-uplets d'ordres quelconques,
- intégrale d'un n-uplet.

Les n-uplets ne sont pas synchrones a priori. Il faut donc pouvoir considérer des suites de n-uplets (ou suites de bandes temporelles). On sait également définir:

- l'égalité de deux suites de n-uplets,
- l'équivalence de deux suites de n-uplets (elles définissent la même enveloppe, avec des découpages temporels différents),

- l'addition de deux suites de n-uplets (ou plus),
- la multiplication d'une suite de n-uplets par un scalaire réel,
- la multiplication d'une suite de n-uplets d'ordre quelconque par un intervalle,
- la multiplication de deux suites de n-uplets d'ordres quelconques.

Il est important de noter que ces opérations sur n-uplets ou bandes n'introduisent par elles-mêmes aucune incertitude supplémentaire.

Par ailleurs, à partir d'un n-uplet, lesdites opérations donnent soit un n-uplet, soit une suite de n-uplets (multiplications, notamment). A partir d'une suite de n-uplets, on obtient toujours une suite de n-uplets.

Revenant à la figure 1, il est envisageable que les mesures d'entrée arrivent directement sous forme de n-uplets. La Demanderesse préfère actuellement mémoriser en 40 les échantillons eux-mêmes. Une unité 42 les convertit en n-uplets correspondants, qu'elle mémorise.

Partant d'un bloc donné d'échantillons d'entrée $(V_{p1}(t_0),... V_{p1}(t_f))$ l'opérateur de conversion (42) est agencé pour opérer une optimisation entre le nombre de n-uplets et leur étendue en ordonnée. Pour simplifier l'exposé, on admettra ci-après que chaque bloc d'échantillons d'entrée est représenté par un seul n-uplet (ou bande).

De la sorte, on va disposer de plusieurs bandes relatives à des points $p_1$, $p_2$ et $p_8$ du réseau, par exemple (Figure 1).

Par ailleurs, de manière prédéterminée, ou par apprentissage au fil des mesures (non représenté), on dispose d'une carte du réseau en 2.

On considère maintenant les modèles.

Les modèles de base sont définis par des lois physiques. Des règles simples permettent de désigner les grandeurs qui sont directement mesurables: par exemple, en électronique, ce sont seulement les tensions, sous réserve de l'accessibilité du point de mesure, qui relève de la carte du réseau.

A l'aide d'un logiciel de calcul formel, comme MATHEMATICA ou MAPLE (marques déposées), vendu par WOLFRAM RESEARCH, ou WATERLOO MAPLE, il est généralement possible de résoudre les équations théoriques, afin d'exprimer des "équations réduites" satisfaisant la condition suivante: chaque équation réduite ne fait intervenir que des grandeurs directement mesurables.

On convertira ensuite chaque équation réduite en une relation-modèle, comme indiqué ci-après.

Bien qu'une seule ou quelques relations-modèles puissent suffire pour le diagnostic d'un ensemble de composants, la Demanderesse préfère actuellement disposer d'un grand nombre de relations-modèles, mieux encore de toutes les relations-modèles possibles pour chaque ensemble de composants. (Toutes les relations-modèles possibles s'entend ici sous les limitations précitées: grandeurs mesurables uniquement, et chaque grandeur n'intervient qu'une fois).

Avantageusement, on fera en sorte qu'une grandeur mesurable (ou l'une de ses dérivées, ou l'une de ses intégrales) n'intervienne qu'une seule fois dans une équation réduite. C'està-dire qu'on "factorise" au maximum les grandeurs mesurables.

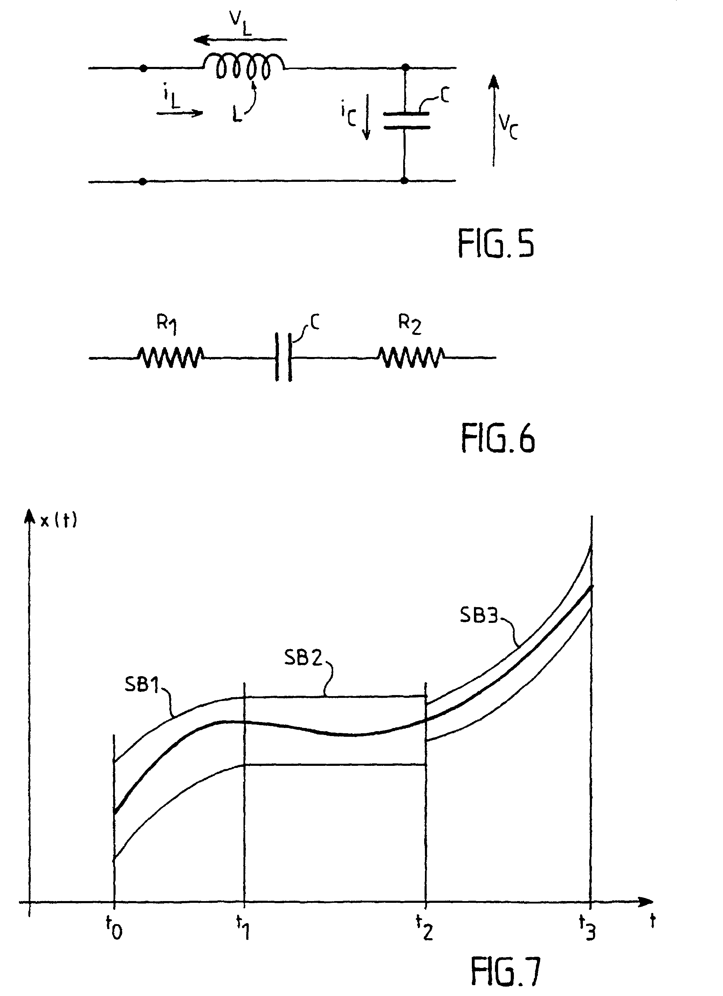

La figure 5 illustre le cas simple d'un quadripôle constitué d'une inductance L en série, suivie d'un condensateur C en parallèle. L'ensemble des équations différentielles décrivant ce circuit est donné par les relations (X) annexées, où les symboles ' (prime) et " (seconde) désignent respectivement les dérivées temporelles d'ordres 1 et 2.

Comme seules les grandeurs $V_L$ et $V_C$ sont mesurables, il ne reste ici qu'une équation réduite, exprimée en (XI).

La figure 6 illustre un autre cas simple où un quadripôle comprend, en série, une résistance R1, un condensateur C et une résistance R2. Les trois équations réduites correspondantes sont exprimées en (XII).

Les travaux actuels montrent que ceci devrait être toujours possible là où les équations théoriques sont linéaires.

La Demanderesse a encore observé qu'il est généralement possible d'intégrer (au sens mathématique) les équations réduites, jusqu'à ne plus avoir que des fonctions dérivées premières temporelles, c'est-à-dire une expression de la forme donnée en relation (XIII). C'est ainsi que l'on va obtenir les relations-modèles.

L'équation réduite (XII) peut s'exprimer directement de cette manière, comme indiqué par les expressions (XIV), qui donnent les désignations Df et Dg, respectivement pour les fonctions f() et g(). (Les guillemets délimiteurs manifestent qu'il s'agit de l'écriture littérale des fonctions concernées).

L'équation réduite (XI) nécessite une intégration, dont le résultat est exprimé en (XV), en supposant que le point de départ de l'intégration est $\Theta_0$. Cette intégration suppose aussi que les paramètres électriques L et C ne varient pas au cours du temps, ce qui est généralement vrai.

L'écriture littérale Df et Dg des fonctions f( ) et g( ) de la relation-modèle correspondant à l'équation réduite (XI) est exprimée en (XVI). Pour Df, on notera que $t_0$ ainsi que $V'_C(t_0)$ sont des constantes.

Plus généralement, en procédant à de telles intégrations, on aboutira à une fonction f( ) (éventuellement à une fonction g( )) incluant diverses constantes, qui pourront comprendre un instant particulier (ici $t_0$), et des valeurs, en ce même instant, de dérivées temporelles successives (de divers ordres) de certaines des grandeurs mesurables impliquées dans la relation-modèle.

Au vu des équations théoriques décrivant la plupart des composants (électroniques ou autres), l'homme du métier comprendra que l'on aboutit la plupart du temps à des équations réduites comprenant des dérivées temporelles jusqu'à l'ordre 2 (au plus). Il suffit alors d'une seule intégration. Cependant, le traitement de dérivées d'ordre supérieur, avec plus d'une intégration, est envisageable pour certaines applications.

Il résulte de ce qui précède que la fonction f( ) peut comporter une intégrale, et/ou une intégrale d'intégrale (jusqu'au degré nécessaire). Les principes de calcul sur n-uplets donnés plus haut ont montré que l'on sait calculer l'intégrale d'un n-uplet.

Restent les constantes que peut comporter la fonction f( ). Un temps, comme $t_0$, est immédiatement disponible. Les valeurs, à un instant donné, de dérivées temporelles de grandeurs mesurables peuvent être calculées de manière connue, à partir des valeurs des échantillons initialement disponibles pour la grandeur physique concernée.

Faire les calculs sur n-uplets nécessite le plus souvent que les n-uplets soient synchrones. Il suffit à cet effet de découper les n-uplets opérandes autant que nécessaire pour arriver à n'avoir que des n-uplets synchrones dans chaque opération qui le nécessite.

Les traitements de calcul formel requis pour obtenir les relations-modèles peuvent être faits a priori, et ne sont donc pas nécessairement incorporés au dispositif proposé. Toutefois, un dispositif polyvalent de diagnostic devra en principe pouvoir calculer les relations-modèles pour une grande variété de circuits à diagnostiquer. A cet effet, il comprendra des moyens de calcul formel sur des fonctions algébriques, leurs primitives et leurs dérivées, pour les nombres réels (dans la limite de précision d'un traitement informatique).

Après avoir engendré les modèles, on stocke, dans une mémoire de base (ou de modèles) 5, des données représentant, pour chaque relation-modèle;

- l'ensemble ou jeu $L_p$ des grandeurs mesurables concernées,

ou des points de mesure, si un seul type de grandeur est mesuré,

- le modèle proprement dit qui comprend les désignations Df et Dg de deux fonctions f( ) et g( ), à appliquer selon une équation comme l'équation (XIII) ou une expression équivalente, et
- l'ensemble $L_v$ des composants concernés par ce modèle.

On notera que le jeu $L_p$ n'est pas impérativement stocké lui-même, puisqu'il est déterminable à partir des désignations de fonctions Df et Dg.

Si l'équation n'est pas vérifiée (même en un seul instant), il en découle que l'un au moins des composants de l'ensemble $L_v$ est défectueux. Recouper plusieurs informations de ce genre pour déterminer quel est le composant défectueux est une opération de logique, connue de l'homme du métier (notamment par EP-A-408 425).

Les désignations Df, Dg des fonctions f() et g() peuvent être des chaînes de caractères, ou d'autres représentations utilisées dans les logiciels de calcul formel. La désignation d'une fonction "vide", par exemple Df = " " visant la fonction identiquement nulle f() = 0, est admise.

La figure 1 illustre, dans la mémoire 5, le cas d'un modèle concernant les tensions $V_{p1}$, $V_{p2}$, et $V_{p8}$, pour une équation définie par les désignations de fonctions Df et Dg, intéressant les composants $c_1$, $c_2$, $c_6$ et $c_8$. On observera au passage que l'ensemble des composants . intéressés par le modèle ne se confond pas avec le jeu des grandeurs mesurables.

De préférence, les modèles sont indexés d'après une composition ordonnée du jeu Lp. Ainsi, le modèle illustré sur la figure 1 est noté "128-0001", pour montrer que c'est le premier qui concerne les points de mesure 1, 2 et 8 ("128"). Des modèles suivants "128-0002" et ainsi de suite sont disponibles pour les mêmes grandeurs. Ceci s'étend à tous les jeux de grandeurs mesurables.

Dans l'unité de traitement 6, une unité de gestion 60 dispose de plusieurs bandes (n-uplets $N_{p1}$, $N_{p2}$, $N_{p8}$) relatives à des points $p_1$, $p_2$ et $p_8$ du réseau, par exemple.

De préférence, dans une unité adjointe 61, on dispose aussi des échantillons initiaux $V_{p1}(t_k)$, $V_{p2}(t_k)$ et $V_{p8}(t_k)$ relatifs aux mêmes points, ou, au moins de ceux de ces échantillons qui seront nécessaires ensuite.

A ces points du réseau correspond l'index "128". En envoyant cet index "128" à la mémoire 5, elle acquiert un à un les modèles concernant le jeu de grandeurs mesurées concernées, en commençant par le modèle "128-0001". Celui-ci comprend des désignations Df("128-0001") et Dg("128-0001") des fonctions f( ) et g( ), ainsi qu'une liste de composants concernés $L_v$("128-0001"). On omettra dans la suite l'expression ("128-0001").

Une unité 62 utilise Df pour y remplacer les constantes par leurs valeurs (si nécessaire). Dans l'exemple de la relation XVI, on calcule "L.C. $V'_C(t_0)$", où L et C sont des intervalles venant de la mémoire 5, tandis que la dérivée première temporelle de $V_C$ en $t_0$, doit être calculée sous forme d'intervalle à partir d'échantillons convenablement choisis dans la mémoire 61, compte tenu de la marge d'incertitude admise. Ce calcul va multiplier trois n-uplets d'ordre zéro, ce qui donne un n-uplet d'ordre zéro. En pratique, le produit "L.C" sera déjà calculé dans Df, et exprimé sous forme d'intervalle.

Une unité 63 fait de même avec Dg, le cas échéant.

Après cela, des unités 64 et 65 vont respectivement calculer sous forme de n-uplets les fonctions f() et g(), en utilisant maintenant les n-uplets des grandeurs mesurées, ici $N_{p1}$, $N_{p2}$ et $N_{p8}$. Les résultats sont un n-uplet Nf (au moins) et un n-uplet Ng (au moins). En pratique, il y aura souvent plusieurs n-uplets à chaque fois, compte-tenu des découpages nécessaires pour faire les calculs sur des n-uplets synchrones (quand c'est nécessaire). Et les n-uplets obtenus pourront être d'ordre supérieur à 1.

Par exemple, la figure 7 illustre une suite de trois n-uplets SB1 (d'ordre 2, les contours supérieur et inférieur sont des segments de parabole), SB2 (d'ordre zéro), et SB3 (à nouveau d'ordre 2).

Intervient maintenant un autre aspect important de l'invention.

La demanderesse a découvert qu'il est possible de tester (par n-uplets) une expression comme f + g' = 0, sans examiner tous les cas possibles. Ce test est effectué dans l'unité 66. La manière de conduire le test dépend du degré maximum des n-uplets Nf et Ng.

Si l'expression est vérifiée (67) tous les composants de la liste $L_v$ sont présumés bons. Dans le cas contraire, l'un au moins des composants $c_1$, $c_2$, $c_6$ et $c_8$ est mauvais, comme l'exprime sous forme logique la relation (XVII), où le symbole ¬ indique la négation logique de l'expression qui le suit, tandis que le symbole V est un "OU logique".

Le diagnostic comporte enfin une logique de décision sur des expressions logiques du même genre, pour déterminer le ou les composants défectueux.

A cet effet, il faut naturellement balayer les différents modèles ("128-0002", etc) pour un même groupe de grandeurs mesurables, et les différents groupes de grandeurs mesurables. Ceci peut se faire de manière systématique, ou en s'orientant compte-tenu des résultats logiques déjà acquis, ou de toute autre manière appropriée. Ce balayage implique une boucle itérative remontant à l'unité de gestion 60 et à sa mémoire annexe 61, boucle qui n'est pas représentée pour alléger le dessin.

Il peut arriver, pour un même jeu de grandeurs mesurables $L_p$ et de composants $L_v$, qu'un modèle ne donne pas d'erreur, tandis qu'un autre en indiquera une.

On reviendra maintenant sur le fonctionnement de l'unité de test 66.

Intégrée une fois sur l'intervalle de temps $[\Theta_0, \Theta_1]$, qui peut être $[t_0, t_1]$, la relation (XIII) devient la relation (XVIII), dans laquelle apparaissent:

- l'intégrale de la fonction f() sur l'intervalle de temps $[\Theta_0, \Theta_1]$, et
- la différence $g(\Theta_1)$ - $g(\Theta_0)$.

Les variables à appliquer aux fonctions f() et g() étant exprimées sous forme de n-uplets, on a vu plus haut que l'on sait réaliser sur des n-uplets les opérations d'intégration, et les opérations algébriques. Il est donc possible d'effectuer un calcul de n-uplets sur une expression du type défini en (XVIII).

La Demanderesse a alors observé que ce travail sur n-uplets présente un avantage essentiel.

Quand on définit les grandeurs utiles par leurs échantillons temporels, il faut vérifier échantillon par échantillon (compte-tenu de l'incertitude) qu'aucun des échantillons n'est incompatible avec le modèle considéré. C'est de là que résulte la complexité des mécanismes de diagnostic antérieurs.

Avec les n-uplets, il devient possible, dans de nombreux cas, de déterminer plus rapidement (sans analyse exhaustive de tous les points contenus dans l'enveloppe) si une expression comme celle de la relation (XVIII) est ou non compatible ("consistante") avec le ou les n-uplets présentés.

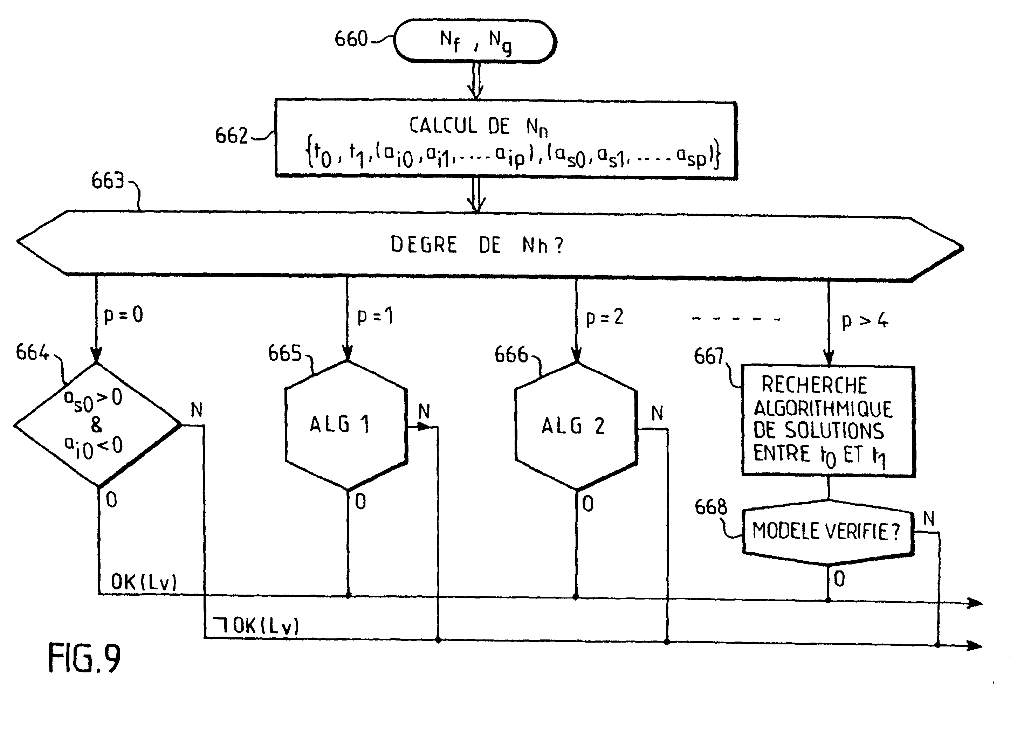

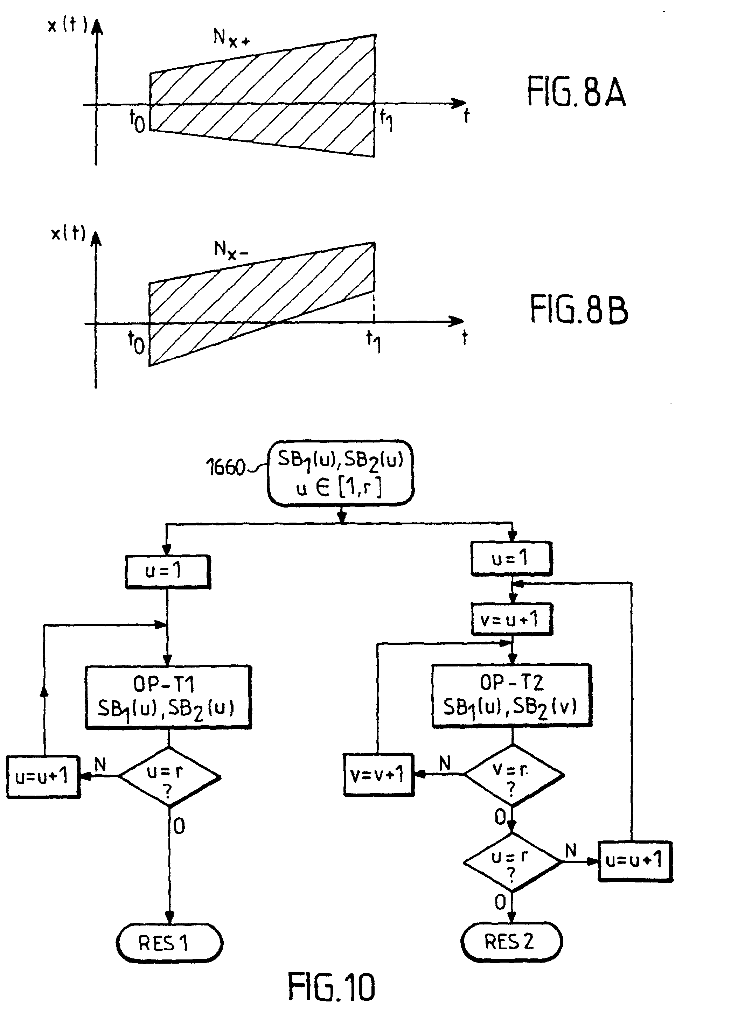

Les figures 8A et 8B l'illustrent, dans le cas de n-uplets d'ordre 1. Il s'agit d'un n-uplet $N_x$, représentant la variation temporelle x(t) d'une grandeur x de $t_0$ à $t_1$. On comprend que:

- le n-uplet $N_{x+}$ est compatible avec l'expression x = 0, car, sur tout l'intervalle $[t_0, t_1]$, l'enveloppe contient la valeur x=0;
- par contre, le n-uplet $N_{x-}$ n'est pas compatible avec l'expression x = 0, car, sur la partie proche de $t_1$ de l'intervalle $[t_0, t_1]$, l'enveloppe ne contient pas la valeur x=0.

Le test a pour but de comparer, en tous points de $[t_0, t_1]$, le signe de l'équation définissant la partie inférieure de l'enveloppe (coefficients $a_i$), au signe de l'équation définissant la partie supérieure de l'enveloppe (coefficients $a_s$).

Avec les n-uplets, ce test devient: l'une au moins des deux équations polynomiales en $a_i$, respectivement en $a_s$, admet-elle une solution sur l'intervalle de temps $[t_0, t_1]$ ?

Reste à examiner quel sera le degré du n-uplet résultat correspondant à une équation ayant la structure standard de la relation (XVIII).

Les opérations sur n-uplets ne changent pas l'ordre ou degré de ceux-ci, sauf pour

- la fonction intégrale (avec une borne variable), qui augmente le degré d'une unité, et
- la multiplication de deux n-uplets dont aucun n'est d'ordre zéro, car l'ordre du résultat est égal à la somme des ordres des n-uplets opérandes.

On part d'un modèle physique - relations (XI) ou (XII) par exemple. Dans ce modèle, la dérivée d'ordre le plus élevé est d'ordre "n", avec n=2 pour la relation (XI) et n=1 pour la relation (XII).

Pour arriver à la structure standard, il faut (n-1) intégrations.

Par ailleurs, dans les fonctions f() et g( ):

- les paramètres électriques (résistances, capacités, etc) sont définis par des intervalles ou par des scalaires (constantes physiques notamment),
- on préfère actuellement que les grandeurs physiques intervenant comme variables soient définies par des n-uplets d'ordre 1.

Compte-tenu des produits de grandeurs qui peuvent intervenir, le degré résultant pour f( ) et g( ) peut augmenter. Cependant, il restera bas dans la grande majorité des cas, et même très souvent égal à 1 ou zéro (par exemple, le n-uplet exprimant que "une tension est constante, à l'incertitude près").

On comprend (Figure 9) que l'unité de test 66 doit établir un n-uplet Nh (étape 662), à partir des n-uplets Nf et Ng (étape 660). Implicitement, on tient compte de l'intégration qui fait passer de l'équation (XIII) à l'équation (XVIII); toutefois, ceci ne change pas le calcul du n-uplet Nh. Ensuite, le degré de Nh est directement déterminable (étape 663) à partir des degrés de Nf et Ng, car il est le maximum entre le degré de Ng, et le degré de Nf +1. L'unité 66 va alors appeler l'outil de résolution d'équations polynomiales, adéquat pour ce degré, afin de déterminer si les équations des courbes inférieure ou supérieure de l'enveloppe du n-uplet Nh admettent des solutions sur l'intervall de temps $[t_0, t_1]$.

Jusqu'à des polynômes de degré 4, que l'on sait résoudre analytiquement, le test est simple. Pour le degré 0, on compare simplement $a_{s0}$ et $a_{i0}$ à 0 (étape 664). Pour les n-uplets de degré 1, le test demeure très simple, puisqu'il suffit (ALG 1) de rechercher si l'un des réels $(-a_{i0} / a_{i1})$ et $(-a_{s0} / a_{s1})$ est compris dans l'intervalle (de réels) $[t_0, t_1]$ (étape 665). Pour p=2 (ou 3 ou 4), on fait de même (ALG 2, etc) avec les solutions analytiques bien connues de l'équation du second degré, à l'étape 666 (respectivement du troisième et du quatrième degré).

Avec des équations polynomiales de degré supérieur à 4 (ce qui sera un cas assez exceptionnel), il faut recourir à des algorithmes numériques de résolution comme déjà indiqué, appliqués pour rechercher s'il existe une solution dans l'intervalle de temps $[t_0, t_1]$, à l'étape 667. Suivant qu'il existe ou non une solution (qu'il n'est pas impératif de calculer), le test 668 fournit la sortie de l'unité 66.

En pratique, on pourra mettre des marges de sécurité convenables dans ces calculs, qui se font sur des nombres réels. Ceci est considéré comme à la portée de l'homme du métier.

Des ambiguïtés peuvent apparaître au niveau des traitements faits dans l'unité 66 elle-même: par exemple, le passage par zéro de la courbe inférieure de la figure 8B n'est-il pas dû à des choix d'enveloppes trop larges en amont ?

Comme on dispose de plusieurs modèles pour chaque ensemble de composants $L_v$ à diagnostiquer, il se trouvera souvent une autre relation-modèle pour indiquer s'il y a ou non un composant défectueux dans l'ensemble $L_v$. En l'absence d'une telle indication complémentaire (ou pour d'autres raisons), on pourra recommencer les traitements de la relation-modèle en cours, en choisissant une suite de n-uplets qui enveloppe de plus près les grandeurs mesurables concernées. Cependant, une enveloppe trop rapprochée des limites d'incertitude implique un risque de diagnostic erroné.

En d'autres termes, au lieu de s'exprimer par "vrai" ($OK(L_v)$) ou "faux" ($\neg OK(L_v)$), la sortie de l'unité 66 pourra admettre une troisième sortie "incertain"; elle pourrait aussi s'exprimer sous la forme d'une sorte de "probabilité" que le jeu de composants $L_v$ contienne au moins un composant défectueux.

Ce qui précède suppose que l'unité 66 calcule le n-uplet Nh. Il peut en résulter un élargissement excessif de l'enveloppe que constitue ce n-uplet.

Cette difficulté est diminuée, avec des relations-modèles ayant la structure de l'équation (XVIII). On décrira maintenant, le fonctionnement préférentiel de l'unité 66, dans l'exemple donné, à deux fonctions f() et g().

On note SB1 et SB2 deux n-uplets ou bandes temporelles. Le modèle est globalement compatible avec ce couple SB1, SB2 si et seulement si il existe deux fonctions F1() et G1(), respectivement encadrées par SB1 et SB2, et vérifiant la relation (XX), où ^ représente le ET logique : pour deux instants quelconques $t_a$, $t_b$, compris, dans cet ordre, dans l'intervalle de temps $[t_0, t_1]$, la relation (XVIII) est vérifiée en y remplaçant $t_0$ par $t_a$, et $t_1$ par $t_b$, f() par F1() et g() par G1().

Des n-uplets SB1 et SB2 d'ordre 1 sont définis par les relations (XXI). On montre que, dans ce cas, les valeurs que peut prendre la fonction H1 de la relation (XX), pour toutes fonctions F1 et G1, mais pour un couple donné d'instants $t_a$ et $t_b$, sont comprises dans l'intervalle donné par la relation (XXII).

La vérification du modèle, pour les deux n-uplets SB1 et SB2 d'ordre 1 se réduit donc à la vérification des quatre conditions des relations (XXIII). Elles expriment que, quels que soient $t_a < t_b$ dans l'intervalle $[t_0, t_1]$, le minimum de l'encadrement de H1 est positif et son maximum est négatif. On retrouve dans les relations (XXIII) la recherche des solutions d'une équation de degré 2 (le degré des n-uplets d'entrée + 1), sur l'intervalle $[t_0,t_1]$.

Cette formulation n'est pas fondamentalement différente du calcul du n-uplet Nh, tel qu'exprimé plus haut. Le calcul est simplement plus direct.

Bien entendu, on évite une intégration dans le cas où la fonction g() est identiquement nulle (seule f() intervient dans le modèle).

Le même processus peut naturellement être utilisé si SB1 et SB2 sont d'ordre supérieur à 1.

Dans ce qui précède, on admet que SB1 et SB2 sont constitués chacun d'un seul n-uplet, respectivement Nf, et Ng.

Mais, lorsqu'on décrit un bloc d'échantillons d'entrée par un seul n-uplet de degré 1, l'enveloppe doit être large; il sera souvent préférable d'utiliser une suite de n-uplets, pour que l'enveloppe soit plus rapprochée (Figure 3). Dès lors, on devra traiter une suite de n-uplets Nf et une suite de n-uplets Ng (autrement dit, une suite de n-uplets pour Nh) au niveau de l'unité 66.

Il reste alors à décrire comment l'unité 66 fonctionne dans le cas où Nf et/ou Ng (donc Nh) sont constitués d'une suite de n-uplets.

On considère donc deux suites synchrones SB1 et SB2 de n-uplets $Nf_u$ et $Ng_u$, avec u allant de 1 à r. Les n-uplets $Nf_1$ et $Ng_1$ sont définis sur l'intervalle de temps $[t_0,t_1]$ ; les n-uplets $Nf_2$ et $Ng_2$ sont définis sur $[t_1,t_2]$, et ainsi de suite jusqu'à $Nf_r$ et $Ng_r$ définis sur $[t_{(r-1)},t_r]$. on pose q=(r-1).

Le problème est de même nature que celui qui a été traité plus haut. Mais il faut maintenant travailler sur tout l'intervalle de temps $[t_0,t_r]$, couvert maintenant par des suites de n-uplets.

La Demanderesse a observé que ce problème peut être décomposé par couples d'intervalles de temps. On considère le couple des intervalles de temps extrêmes, à savoir $[t_0,t_1]$ d'une part, $[t_q.t_r]$ d'autre part.

En raisonnant comme pour les fonctions F1 et G1, plus haut, et avec des n-uplets d'ordre 1, la Demanderesse a montré que le modèle est vérifié si les deux relations (XXIV) et (XXV) sont vérifiées, quel que soit $t_a$ dans $[t_0,t_1]$, et quel que soit $t_b$ dans $[t_q,t_r]$. (Dans ces relations, il faudrait ajouter aux coefficients $a_i$ et $a_s$ non seulement leur rang, mais aussi le rang du n-uplet concerné; pour en alléger la lecture, seul le rang du n-uplet est en indice. Le coefficient de rang 1 pour l'équation polynomiale de la courbe inférieure s'écrit donc $ail_r$ pour le n-uplet $Nf_r$, et $bil_r$ pour le n-uplet $Ng_r$.).

Ces relations expriment:

- en 1° ligne, l'intégrale de SB1 entre $t_a$ et la borne supérieure $t_1$ de $[t_0,t_1]$,
- en 2° ligne, l'intégrale de SB1 entre la borne inférieure $t_q$ de $[t_q,t_r]$ et $t_b$,
- en 3° ligne, l'intégrale de SB1 sur tous les intervalles de temps intermédiaires de $t_1$ à $t_q$,
- en 4° ligne, la contribution de SB2.

Il y a donc lieu ici de calculer le minimum ou le maximum de 4 fonctions du second degré, puis d'y ajouter des constantes.
Ce calcul est simple.

La même procédure peut s'appliquer à tout couple d'intervalles de temps entre $t_0$ et $t_r$.

Pour vérifier complètement le modèle sur deux suites de bandes synchrones SB1 et SB2, il faut donc prévoir (figure 10):

- un opérateur (OP_T1) qui travaille sur chacune des paires de n-uplets synchrones que l'on peut construire entre $t_0$ et $t_r$, comme SB1(u) et SB2(u). Il travaille (r fois) d'après les relations (XXIII), pour fournir un résultat global RES1, indiquant si la compatibilité avec le modèle est violée par une ou plusieurs des paires synchrones.
- un opérateur (OP_T2) qui travaille également sur SB1 et SB2, mais sur toutes les paires différentes (non rangées) que l'on peut construire avec les "r" intervalles de temps. Il travaille selon les relations (XXIV) et (XXV), et ce r(r-1)/2 fois, pour fournir un résultat global RES2, indiquant si la compatibilité avec le modèle est violée par une ou plusieurs des paires différentes d'intervalles de temps.

Ainsi, l'unité 66 peut travailler complètement sur deux suites de n-uplets ou bandes SB1 et SB2.

La description ci-dessus ne concerne que les n-uplets d'ordre 1, alors que des n-uplets d'ordre supérieur ont été envisagés. Pour des n-uplets d'ordre supérieur, on peut:

- soit découper ceux-ci en n-uplets d'ordre 1 (suffisamment brefs pour que la courbe polynomiale soit quasi assimilable à une droite),

- soit appliquer les principes énoncés ci-dessus aux ordres supérieurs, ce qui est possible, mais se traduit par des expressions trop complexes pour être incorporées à la présente description.

Les expressions données dans la description détaillée et en annexe peuvent paraître complexes. Leur calcul est cependant nettement plus rapide que l'examen systématique de tous les échantillons, selon la technique antérieure.

De plus, le dispositif décrit est beaucoup plus puissant: intrinsèquement, il prend en compte ce qui se passe entre les échantillons des mesures.

En outre, les calculs sur n-uplets traitent particulièrement bien les problèmes de dérivées aux endroits où le signal varie rapidement: il suffit de les encadrer localement par une enveloppe rapprochée.

La présente invention n'est naturellement pas limitée au mode . de réalisation décrit en détail.

Par exemple, on peut prévoir que certains (au moins) des modèles comprennent des conditions supplémentaires de validité portant sur des valeurs d'au moins une grandeur mesurée. Cette condition supplémentaire est évaluée avant d'appliquer le modèle, par exemple au niveau de l'unité de gestion. L'évaluation peut se faire par calcul sur n-uplet ou par calcul sur les échantillons initiaux.

Bien entendu, la forme standard (XIII) et (XVIII) utilisée pour écrire les relations-modèles n'est pas limitative. On peut utiliser toute forme équivalente ou construite suivant les mêmes principes.

On pourrait d'ailleurs stocker les relations-modèles sous la forme intégrée (XVIII), au lieu de la forme différentielle (XIII). La relation-modèle se réduit alors à une seule fonction h(), comme indiqué par le second membre de la relation (XVIII).

Cette fonction unique h() pourrait être définie par une seule désignation Dh. L'homme du métier comprendra d'ailleurs que cette désignation Dh est équivalente au couple (Df, Dg). De même, le n-uplet résultant Nh est équivalent au couple de n-uplets (Nf, Ng) décrit plus haut.

Sur un autre plan, on préfère aujourd'hui simplifier au maximum l'écriture des relations-modèles. Il serait cependant concevable qu'une même grandeur y apparaisse plusieurs fois, voire même, dans certains cas, que ces relations-modèles fassent intervenir des grandeurs intermédiaires estimées.

Les outils requis pour les calculs sur n-uplets comprennent la mémorisation de quelques expressions comme tout ou partie de celles données dans l'annexe de formules et leurs extensions aux degrés supérieurs, notamment les équations (I) à (VI), et les relations (XXIII) à (XXV), ainsi que les solutions des équations polynomiales de degrés 1 à 4, et des algorithmes numériques de résolution d'équations polynomiales de degré supérieur à 4, par exemple. Ces outils de calcul peuvent être implantés dans les moyens de calcul sur n-uplets eux-mêmes, ou séparés.

Bien que la description détaillée ci-dessus se réfère essentiellement à des circuits électroniques, il est clair qu'elle est susceptible de nombreuses autres applications, notamment les installations de circulation de fluides, le domaine de la thermique, de la mécanique, et plus généralement tout système que l'on peut décrire au moins partiellement par des équations différentielles, avec une approximation suffisante.

Annexe - Formules (I) à (VIII)

$$\text{(I)} \quad Nx \{t_0, t_1, (a_{i0}, a_{i1}), (a_{s0}, a_{s1})\}$$

$$t_0 \leq t_x \leq t_1$$

$$Nx1 \{t_0, t_x, (a_{i0}, a_{i1}), (a_{s0}, a_{s1})\}$$

$$Nx2 \{t_x, t_1, (a_{i0}, a_{i1}), (a_{s0}, a_{s1})\}$$

$$\text{(II)} \quad Nx1 \{t_0, t_1, (a_{i0}, a_{i1}), (a_{s0}, a_{s1})\} ;$$

$$Nx2 \{t_0, t_1, (b_{i0}, b_{i1}), (b_{s0}, b_{s1})\} ;$$

$$Nx1 + Nx2 = Ny \{t_0, t_1, (a_{i0} + b_{i0}, a_{i1} + b_{i1}), (a_{s0} + b_{s0}, a_{s1} + b_{s1})\}$$

$$\text{(III)} \quad \{t_0, t_1, (a_{i0}, a_{i1}, ..., a_{ip}), (a_{s0}, a_{s1}, ..., a_{sp})\}$$

$$\forall\, t \in [t_0, t_1]\,;$$

$$a_{i0} + a_{i1}\, t + \ldots + a_{ip}\, t^P \le x(t) \le a_{s0} + a_{s1}\, t + \ldots + a_{sp}\, t^P$$

(IV)     $\{t_0, t_1, (a_{i0}, \ldots, a_{ip}), (a_{s0}, \ldots, a_{sp})\}$

$+\, \{t_0, t_1, (b_{i0}, \ldots, b_{ip}), (b_{s0}, \ldots, b_{sp})\}$

$=\, \{t_0, t_1, (a_{i0} + b_{i0}, \ldots, a_{ip} + b_{ip}), (a_{s0} + b_{s0}, \ldots, a_{sp} + b_{sp})\}$

$$\text{(V)} \quad \int_{\Theta_0}^{t} \{t_0, t_1, (a_{i0}, a_{i1} \ldots, a_{ip}), (a_{s0}, a_{s1} \ldots, a_{sp})\}\ dt$$

$$= \{t_0, t_1,$$

$$(- \sum_{j=0}^{n} a_{ij}\, \Theta_0^{(j+1)}/(j+1)\ , a_{i0}, a_{i1}/2, \ldots, a_{ip}/(p+1)),$$

$$(- \sum_{j=0}^{n} a_{sj}\, \Theta_0^{(j+1)}/(j+1)\ , a_{s0}, a_{s1}/2, \ldots, a_{sp}/(p+1))\},$$

$$\text{(VI)} \quad \int_{0}^{t} \{t_0, t_1, (a_{i0}, a_{i1} \ldots, a_{ip}), (a_{s0}, a_{s1} \ldots, a_{sp})\}\ dt$$

$$= \{t_0, t_1, (0, a_{i0}, a_{i1}/2, \ldots, a_{ip}/(p+1)), (0, a_{s0}, a_{s1}/2, \ldots, a_{sp}/(p+1))\}$$

(VII)     $\{t_0, t_1, (a_{i0}\, b_{i0}, a_{i1}\, b_{i0}), (a_{s0}\, b_{i0}, a_{s1}\, b_{i0})\}$

(VIII)     $\{t_0, t_1, (a_{i0}\, b_{i0}, a_{i1}\, b_{i0}), (a_{s0}\, b_{s0}, a_{s1}\, b_{s0})\}$

Annexe - Formules (X) à (XVIII)

(X)     $V_L = L \cdot i'_L$

$i_C = C \cdot V'_C$

$i_L - i_C = 0$

(XI) $V_L = L \cdot C \cdot V''_C$

(XII)     $V_1/R_1 = C \cdot V'_C$

$$V_2/R_2 = C \cdot V'_C$$

$$V_1/R_1 = V_2/R_2$$

$$(XIII) \qquad f() + g'() = 0$$

$$(XIV) \qquad Df = "V_1 / R_1"$$

$$Dg = "-C \cdot V'_C"$$

$$(XV) \qquad \int_{\Theta_0}^{t} (V_L - L.C.\ V''_C)\ dt = 0$$

$$\int_{\Theta_0}^{t} V_L\ dt - L.C.\ V'_C(t) + L.C.\ V'_C(t_0) = 0$$

$$(XVI) \qquad Df = "\int_{\Theta_0}^{t} V_L\ dt + L.C.\ V'_C(t_0)\ "$$

$$Dg = "- L.C.\ V'_C(t)"$$

$$(XVII) \qquad \neg OK(L_v) = (\ \neg OK(c_1) \vee \neg OK(c_2) \vee \neg OK(c_6) \vee \neg OK(c_8)\ )$$

$$(XVIII) \qquad \int_{\Theta_0}^{\Theta_1} f().dt + g(\Theta_1) - g(\Theta_0) = h() = 0$$

Annexe - Formules (XX) à (XXV)

$$(XX)\ \ \forall t_a, t_b \in [t_0, t_1], t_a < t_b\ \ \wedge\ \ \int_{t_a}^{t_b} F1().dt + G1(t_b) - G2(t_a) = H1 = 0$$

$$(XXI) \qquad SB1\ \{t_0, t_1, (a_{i0}, a_{i1}), (a_{s0}, a_{s1})\}\ ;$$

SB2 $\{t_0, t_1, (b_{i0}, b_{i1}), (b_{s0}, b_{s1})\}$

$$(\text{XXII}) \qquad [a_{i1}/2 \, (t_b^2 - t_a^2) + a_{i0}(t_b - t_a) + b_{i1} \, t_b + b_{i0} - b_{s1} \, t_a - b_{s0} \, ,$$

$$a_{s1}/2 \, (t_b^2 - t_a^2) + a_{s0} \, (t_b - t_a) + b_{s1} \, t_b + b_{s0} - b_{i1} \, t_a - b_{i0} \, ]$$

$$(\text{XXIII}) \qquad \text{pour } t \in [t_0, t_1] \, ,$$

$$\text{Max} \, (a_{i1}/2 \, (t^2 - t_0^2) + (a_{i0} + b_{i1})t - (a_{i0} + b_{s1})t_0 + b_{i0} - b_{s0} \, ) \le 0$$

$$\text{Max} \, (a_{i1}/2 \, (t_1^2 - t^2) + (a_{i0} + b_{i1})t_1 - (a_{i0} + b_{s1})t + b_{i0} - b_{s0} \, ) \le 0$$

$$\text{Min} \, (a_{s1}/2 \, (t^2 - t_0^2) + (a_{s0} + b_{s1})t - (a_{s0} + b_{i1})t_0 + b_{s0} - b_{i0} \, ) \ge 0$$

$$\text{Min} \, (a_{s1}/2 \, (t_1^2 - t^2) + (a_{s0} + bs_1)t_1 - (a_{s0} + b_{i1})t + b_{s0} - b_{i0} \, ) \ge 0$$

$$(\text{XXIV}) \; \text{pour } t_a \in [t_0, t_1] \; \text{et } t_b \in [t_q, t_r]$$
$$\text{Max}(-ai1_1/2 \, t_a^2 - ai0_1 \, t_a) + ai1_1/2 \, t_1^2 + ai0_1 \, t_1$$
$$+ \; \text{Max}(ai1_r/2 \, t_b^2 + ai0_r \, t_b) \; - ai1_r/2 \, t_q^2 - ai0_r \, t_q$$
$$+ \sum_{k=2}^{q} \, (ai1_k/2 \, (t_k^2 - t_{k-1}^2) + ai0_k \, (t_k - t_{k-1})$$
$$+ \, bi1_r \, t_b + bi0_r \; - \; bs1_1 \, t_a - bs0_1 \quad < \quad 0$$

$$(\text{XXV}) \; \text{pour } t_a \in [t_0, t_1] \; \text{et } t_b \in [t_q, t_r]$$
$$\text{Min}(-as1_1/2 \, t_a^2 - as0_1 \, t_a) + as1_1/2 \, t_1^2 + as0_1 \, t_1$$
$$+ \; \text{Min}(as1_r/2 \, t_b^2 + as0_r \, t_b) - as1_r/2 \, t_q^2 - as0_r \, t_q$$
$$+ \sum_{k=2}^{q} \, (as1_k/2 \, (t_k^2 - t_{k-1}^2) + as0_k \, (t_k - t_{k-1})$$
$$+ \, bs1_r \, t_b + bs0_r \; - \; bi1_1 \, t_a - bi0_1 \quad < \quad 0$$

**Revendications**

1. Dispositif d'aide au diagnostic d'un réseau de composants, du type comportant:

   - une mémoire d'entrée (4) pour recevoir des blocs de mesures, dont chacun représente des mesures d'une grandeur physique effectuées en un emplacement connu du réseau,
   - une mémoire de base (5), pour stocker la définition de modèles fonctionnels relatifs au réseau, et
   - des moyens de traitement (6,8) capables de déterminer si un modèle fonctionnel est vérifié ou non par un ou des blocs de mesures, afin d'identifier un éventuel défaut de l'un au moins des composants du réseau,

**caractérisé en ce qu'**il comporte en outre des moyens de calcul (62-65) sur des n-uplets, qui représentent l'évolution temporelle d'une variable, chaque n-uplet définissant un intervalle de temps, et un domaine en bande encadrant l'evolution de la variable sur cet intervalle de temps, ainsi que des moyens de test (66) propres à recevoir un ou des n-uplets (Nf,Ng), et à fournir une sortie relative à la vérification d'une expression standard par ces n-uplets,

**en ce que**, dans la mémoire d'entrée (42), chaque bloc de mesures est stocké sous la forme d'au moins un n-uplet initial,

**en ce que**, dans la mémoire de base (5), la définition d'un modèle fonctionnel comprend une liste de composants ($L_v$), et la désignation (Df, Dg) d'au moins une fonction particulière des grandeurs mesurables ($L_p$),

et **en ce que** les moyens de traitement (6) comprennent en outre des moyens de gestion, capables, répétitivement,

- de coopérer (60-61) avec la mémoire de base, pour faire correspondre des n-uplets initiaux disponibles, et au moins un modèle applicable aux grandeurs mesurables que représentent ces n-uplets,
- de faire appel (62-65) aux calculs sur n-uplets, avec la désignation de fonction (Df,Dg) du modèle, et ces n-uplets, pour obtenir au moins un n-uplet résultat (Nf,Ng),
- d'appliquer le n-uplet résultat (Nf, Ng) aux moyens de test (66), et
- d'associer la sortie des moyens de test à la liste de composants ($L_v$) du modèle,

ainsi qu'une logique de décision, capable d'analyser différentes sorties des moyens de test, en vue de déterminer un ou des composants défectueux.

2. Dispositif selon la revendication 1, **caractérisé en ce que** les modèles portent uniquement sur des grandeurs directement mesurables.

3. Dispositif selon la revendication 2, **caractérisé en ce que** chaque grandeur mesurable intervient au plus une fois dans chaque désignation de fonction (Df,Dg) d'un modèle.

4. Dispositif selon l'une des revendications précédentes, **caractérisé en ce que**, pour les n-uplets initiaux, le domaine en bande le domaine en bande est délimitée comme un trapèze ($O_{a1}$ $O_{a2}$, $O_{b1}$ $O_{b2}$).

5. Dispositif selon l'une des revendications précédentes, **caractérisé en ce qu'**il comprend en outre un opérateur de conversion (42), apte à transformer des valeurs de mesures d'entrée ($V_{p1}(t)$) en au moins un n-uplet initial ($N_{p1}$).

6. Dispositif selon la revendication 5, **caractérisé en ce que** l'opérateur de conversion (42) est agencé pour opérer une optimisation entre le nombre de n-uplets et leur étendue en ordonnée.

7. Dispositif selon l'une des revendications précédentes, **caractérisé en ce qu'**il comprend en outre des moyens (70) de calcul formel sur des fonctions algébriques, leurs primitives et leurs dérivées, pour les nombres réels, et **en ce que** les moyens de calcul sur des n-uplets font appel à ces moyens de calcul formel.

8. Dispositif selon l'une des revendications précédentes, **caractérisé en ce que** les moyens (6) de calcul sur des n-uplets sont agencés pour effectuer:

- la composition de n-uplets, pour les segmenter et/ou les enchaîner, ce qui permet d'obtenir des n-uplets dits "synchrones", relatifs à un même intervalle de temps,
- les calculs algébriques sur des n-uplets, éventuellement rendus synchrones,
- l'intégration d'un n-uplet sur une partie au moins de son intervalle de temps.

9. Dispositif selon l'une des revendications précédentes, **caractérisé en ce qu'**il comporte des moyens (2) pour recevoir ou construire une carte du réseau à diagnostiquer, et un générateur (3) de relations-modèles à partir de cette carte et de lois physiques sur les composants du réseau.

10. Dispositif selon l'une des revendications précédentes, **caractérisé en ce que** les moyens de test (66) sont affectés à une structure standard d'équations différentielles, telle que f( ) + g'( ) = 0, **en ce qu'**ils sont propres à recevoir d'une part des désignations Df et Dg de fonctions f( ) et g( ) particulières, et d'autre part des n-uplets concernant les variables de ces fonctions f( ) et g( ) particulières, et **en ce qu'**ils sont agencés pour fournir une sortie logique relative à la vérification de l'équation différentielle par les variables.

**11.** Dispositif selon la revendication 10, **caractérisé en ce que** les moyens de calcul (62-65) sont capables, pour un modèle, de fournir au moins un n-uplet résultat (Nf), pour la fonction f() particulière désignée par Df, et des n-uplets de grandeurs mesurables qu'elle implique, et au moins un n-uplet résultat (Ng), pour la fonction g() particulière désignée par Dg, et des n-uplets des grandeurs mesurables qu'elle implique.

**12.** Dispositif selon la revendication 11, **caractérisé en ce que**, les moyens de calcul (62-65) fournissant une suite (SB1) de n-uplets résultats (Nf), pour la fonction f( ) particulière désignée par Df, et une suite (SB2) de n-uplets résultats (Ng), pour la fonction g( ) particulière désignée par Dg, les moyens de test (66) comprennent:

- un opérateur apte à travailler sur une paire de n-uplets synchrones respectivement pris dans les deux suites (SB1(u),SB2(u)), et
- un opérateur apte à travailler globalement sur une première paire de n-uplets synchrones des deux suites (SB1(1),SB2(1)) et sur une seconde paire de n-uplets synchrones des deux suites (SB1(r),SB2(r)), relative à un intervalle de temps dont les bornes sont respectivement associées à la première et à la seconde paires de n-uplets.

**Patentansprüche**

**1.** Hilfsvorrichtung für die Diagnose eines Netzes von Bauelementen, enthaltend:

- einen Eingangsspeicher (4) zum Aufnehmen von Meßwerteblöcken, von denen jeder Meßwerte einer physikalischen Größe repräsentiert, die an einem bekannten Ort des Netzes aufgenommen wurden,
- einen Basisspeicher (5) zum Speichern der Definition von Funktionsmodellen, die sich auf das Netz beziehen, und
- Verarbeitungseinrichtungen (6, 8), die in der Lage sind zu ermitteln, ob ein Funktionsmodell durch einen oder mehrere Meßwerteblöcke überprüft ist, um einen eventuellen Fehler wenigstens eines der Bauelemente des Netzes zu identifizieren,

**dadurch gekennzeichnet, daß** sie weiterhin Berechnungseinrichtungen (62-65) für N-tette enthält, die die zeitliche Entwicklung einer Variablen repräsentieren, wobei jedes N-tett ein Zeitintervall bestimmt und ein bandförmiger Bereich die Entwicklung der Variablen in diesem Zeitintervall umrahmt, sowie Prüfeinrichtungen (66) enthält, die dazu geeignet sind, einen oder mehrere N-tette (Nf, Ng) aufzunehmen und einen Ausgang zu liefern, der sich auf die Verifizierung eines Standardausdrucks durch diese N-tette bezieht, daß in dem Eingangsspeicher (42) jeder Meßwerteblock in Form von wenigstens einem Anfangs-N-tett gespeichert ist,
daß in den Basisspeichern (5) die Definition eines Funktionsmodells eine Liste von Bauelementen ($L_v$) und die Bezeichnung (Df, Dg) wenigstens einer speziellen Funktion meßbarer Größen ($L_p$) enthält,
und daß die Verarbeitungseinrichtungen (6) weiterhin Verwaltungseinrichtungen enthalten, die in der Lage sind, wiederholend
mit dem Basisspeicher zusammenzuwirken (60-61), um verfügbare Anfangs-N-tette und wenigstens ein auf meßbare Größen, die diese N-tette repräsentieren, anwendbares Modell in Übereinstimmung zu bringen,
die Berechnungen der N-tette mit der Bezeichnung der Funktion (Df; Dg) des Modells und dieser N-tette aufrufen zu lassen, um wenigstens ein Ergebnis-N-tett (Nf, Ng) zu erhalten,
das Ergebnis-N-tett (Nf, Ng) bei den Prüfeinrichtungen (66) anzuwenden, und
den Ausgang der Prüfeinrichtungen der Liste der Bauelemente ($L_v$) des Modells zuzuordnen,
und eine Entscheidungslogik enthält, die in der Lage ist, verschiedene Ausgänge der Prüfeinrichtungen zum Zwecke der Bestimmung eines oder mehrerer defekter Bauelemente zu analysieren.

**2.** Vorrichtung nach Anspruch 1, **dadurch gekennzeichnet, daß** die Modelte sich einzig auf direkt meßbare Größen erstrecken.

**3.** Vorrichtung nach Anspruch 2, **dadurch gekennzeichnet, daß** jede meßbare Größe höchstens einmal in jede Funktionsbezeichnung (Df, Dg) eines Modells eingeht.

**4.** Vorrichtung nach einem der vorhergehenden Ansprüche, **dadurch gekennzeichnet, daß** für die Anfangs-N-tette der Bandbereich wie ein Trapez ($O_{a1}$ $O_{a2}$, $O_{b1}$ $O_{b2}$) umgrenzt ist.

**5.** Vorrichtung nach einem der vorhergehenden Ansprüche, **dadurch gekennzeichnet, daß** sie weiterhin einen Wandler (42) enthält, der dazu eingerichtet ist, Eingangsmeßwerte ($V_{p1}$ (t)) in wenigstens ein Anfangs-N-tett ($N_{p1}$) zu transformieren.

**6.** Vorrichtung nach Anspruch 5, **dadurch gekennzeichnet, daß** der Wandler (42) dazu eingerichtet ist, eine Optimierung zwischen der Zahl der N-tette und ihrer Ordinatenerstreckung auszuführen.

**7.** Vorrichtung nach einem der vorhergehenden Ansprüche, **dadurch gekennzeichnet, daß** sie weiterhin Formberechnungseinrichtungen (70) für algebraische Funktionen, ihre Glieder und ihre Ableitungen für die reellen Zahlen enthält und daß die Berechnungseinrichtungen für die N-tette auf diese Formberechnungseinrichtungen zugreifen.

**8.** Vorrichtung nach einem der vorhergehenden Ansprüche, **dadurch gekennzeichnet, daß** die Berechnungseinrichtung (60) für N-tette dazu eingerichtet sind, Folgendes auszuführen:

die Zusammenstellung von N-tetten, um sie zu segmentieren und/oder sie aufzureihen, was es erlaubt, "synchron" genannte N-tette zu erhalten, die sich auf ein gleiches Zeitintervall beziehen,

algebraische Berechnungen der N-tette, die eventuell synchron gemacht sind,

die Integration eines N-tetts über wenigstens einen Teil seines Zeitintervalls.

**9.** Vorrichtung nach einem der vorhergehenden Ansprüche, **dadurch gekennzeichnet, daß** sie Einrichtungen (2) zum Aufnehmen oder Konstruieren einer Karte des zu diagnostizierenden Netzes und einen Erzeuger (3) von Modellbeziehungen aus dieser Karte und physikalischen Gesetzen über die Bauelemente des Netzes enthält

**10.** Vorrichtung nach einem der vorhergehenden Ansprüche, **dadurch gekennzeichnet, daß** die Prüfeinrichtungen (66) einer Standardstruktur von Differentialgleichungen, wie f( ) + g'( ) = 0 zugewiesen sind und daß sie dazu eingerichtet sind, einerseits die Bezeichnungen Df und Dg von speziellen Funktionen f( ) und g( ) und andererseits N-tette aufzunehmen, die die Variablen dieser speziellen Funktionen f( ) und g( ) betreffen, und daß sie dazu eingerichtet sind, einen logischen Ausgang zu liefern, der sich auf die Verifizierung der Differentialgleichung durch die Variablen bezieht.

**11.** Vorrichtung nach Anspruch 10, **dadurch gekennzeichnet, daß** die Berechnungseinrichtungen (62-65) in der Lage sind, für ein Modell wenigstens ein Resultat-N-tett (Nf) für die durch Df bezeichnete spezielle Funktion f( ) und N-tette von sie enthaltende Meßgrößen und wenigstens ein Resultat-N-tett (Ng) für die durch Dg bezeichnete spezielle Funktion g( ) und N-tette von sie enthaltende Meßgrößen zu liefern.

**12.** Vorrichtung nach Anspruch 11, **dadurch gekennzeichnet, daß** die Berechnungseinrichtungen (62-65) eine Folge (SB1) von Resultat-N-tetten (Nf) für die durch Df bezeichnete spezielle Funktion f( ) und eine Folge (SB2) von Resultat-N-tetten (Ng) für die durch Dg bezeichnete spezielle Funktion g( ) liefern, und die Prüfeinrichtungen (66) enthalten:

- einen Operator, der dazu eingerichtet ist, ein Paar synchroner N-tette zu verarbeiten die in den zwei Folgen (SB1 (u), SB2 (u)) enthalten sind, und
- einen Operator, der dazu eingerichtet ist, global ein erstes Paar synchroner N-tette der zwei Folgen (SB1 (1), SB2 (1)) und ein zweites Paar synchroner N-tette der zwei Folgen (SB1 (r), SB2 (r)) zu verarbeiten, die sich auf ein Zeitintervall beziehen, dessen Grenzen den ersten und zweiten N-tett-Paaren zugeordnet sind.

**Claims**

**1.** Device for aiding the diagnosis of a network of components, of the type including:

- an input memory (4) for receiving blocks of measurements, each of which represents measurements of a physical quantity made at a known location of the network,
- a base memory (5) for storing the definition of functional models relating to the network, and
- processing means (6, 8) capable of determining whether a functional model is or is not satisfied by one or more blocks of measurements, so as to identify a possible fault in one at least of the components of the network,

**characterized in that** it furthermore includes means (62-65) for computing on n-tuples, which represent the time evolution of a variable, each n-tuple defining a time interval, and a strip-like domain bracketing the evolution of the variable over this time interval,

as well as test means (66) able to receive one or more n-tuples (Nf, Ng), and to yield an output relating to the satisfying of a standard expression by these n-tuples,

**in that**, in the input memory (42), each block of measurements is stored in the form of at least one initial n-tuple,

**in that**, in the base memory (5), the definition of a functional model comprises a list of components ($L_v$), and the designation (Df, Dg) of at least one particular function of the measurable quantities ($L_p$), and **in that** the processing means (6) furthermore comprise management means capable, repetitively,

- of cooperating (60-61) with the base memory, so as to match up the available initial n-tuples, and at least one model applicable to the measurable quantities which these n-tuples represent,
- of deploying (62-65) the computations on n-tuples, with the function designation (Df, Dg) of the model, and these n-tuples, to obtain at least one result n-tuple (Nf, Ng),
- of applying the result n-tuple (Nf, Ng) to the test means (66), and
- of associating the output from the test means with the list of components ($L_v$) of the model,
  as well as decision logic, capable of analysing various outputs from the test means, with a view to determining one or more defective Components.

2. Device according to Claim 1, **characterized in that** the models pertain solely to directly measurable quantities.

3. Device according to Claim 2, **characterized in that** each measurable quantity enters at most once into each function designation (Df, Dg) of a model.

4. Device according to one of the preceding claims, **characterized in that**, for the initial n-tuples, the strip-like domain is delimited as a trapezium ($O_{a1}\ O_{a2},\ O_{b1}\ O_{b2}$).

5. Device according to one of the preceding claims, **characterized in that** it furthermore comprises a conversion operator (42), able to transform input measurement values ($V_{p1}(t)$) into at least one initial n-tuple ($N_{p1}$).

6. Device according to Claim 5, **characterized in that** the conversion operator (42) is designed to operate an optimization between the number of n-tuples and their span along the ordinate.

7. Device according to one of the preceding claims, **characterized in that** it furthermore comprises means (70) of formal computation on algebraic functions, their primitives and their derivatives, for the real numbers, and **in that** the means of computation over n-tuples deploy these means of formal computation.

8. Device according to one of the preceding claims, **characterized in that** the means (6) of computation over n-tuples are designed to perform:

- the composition of n-tuples, so as to segment them and/or concatenate them, thus making it possible to obtain so-called "synchronous" n-tuples relating to one and the same time interval,
- the algebraic computations over n-tuples, possibly rendered synchronous,
- the integration of an n-tuple over a part at least of its time interval.

9. Device according to one of the preceding claims, **characterized in that** it includes means (2) for receiving or constructing a map of the network to be diagnosed, and a generator (3) of model-relations from this map and from physical laws regarding the components of the network.

10. Device according to one of the preceding claims, **characterized in that** the test means (66) are assigned to a standard structure of differential equations, such as f( ) + g'( ) = 0, **in that** they are able to receive on the one hand, designations Df and Dg of particular functions f( ) and g( ), and on the other hand, n-tuples relating to the variables of these particular functions f( ) and g( ), and **in that** they are designed to yield a logic output relating to the satisfying of the differential equation by the variables.

11. Device according to Claim 10, **characterized in that** the computation means (62-65) are capable, for a model, of yielding at least one result n-tuple (Nf), for the particular function f( ) designated by Df, and n-tuples of measurable quantities which it involves, and at least one result n-tuple (Ng) for the particular function g( ) designated by Dg, and n-tuples of measurable quantities which it involves.

12. Device according to Claim 11, **characterized in that** the computation means (62-65) yielding a sequence (SB1) of result n-tuples (Nf), for the particular function f( ) designated by Df, and a sequence (SB2) of result n-tuples (Ng), for the particular function g( ) designated by Dg, the test means (66) comprise:

- an operator able to work on a pair of synchronous n-tuples respectively taken from the two sequences (SB1 (u), SB2(u)), and
- an operator able to work globally on a first pair of synchronous n-tuples from the two sequences (SB1(1), SB2 (1)) and on a second pair of synchronous n-tuples from the two sequences (SB1(r), SB2(r)), which relates to a time interval whose bounds are respectively associated with the first and with the second pairs of n-tuples.

1 — RESEAU A TESTER

2 — CARTE DU RESEAU

3 — GENERATEUR DE MODELES

4

40 — MESURES :
$V_{p1}(t_0)$ ..... $V_{p1}(t_f)$

42 — BANDE $V_{p1}$
$N_{p1}\{t_0, t_1, (a_{i0}, a_{i1}), (a_{s0}, a_{s1})\}$

5 — MODELES FONCTIONNELS

"128 - 0001"

$L_p$ : $V_{p1}, V_{p2}, V_{p8}$
$E_q$ : $D_f$, $D_g$
$L_v$ : $C_1, C_2, C_6, C_8$

"128 - 0002"

"128 - 0003"

VALEURS
$V_{p1}(t_k)$
$V_{p2}(t_k)$
$V_{p8}(t_k)$ — 61

BANDES $V_{p1}$ , $V_{p2}$ , $V_{p8}$
N-uplets $N_{p1}\{\}, N_{p2}\{\}, N_{p8}\{\}$

60

"128"

$D_f$

$D_g$

62 — Fonction f( )
Calcul des constantes

63 — Fonction q( )
Calcul des constantes

6

64 — Calcul de f( ) sur n-uplets

65 — Calcul de g( ) sur n-uplets

66

Vrai

Test de $f + g' = 0$
sur $N_f$ et $N_g$ (selon leur ordre)

Faux

$N_f$

$N_g$

$L_v$

67 — OK($L_v$)

68 — $\neg$OK($L_v$)

8 — LOGIQUE DE DECISION
SUR LES $L_v$ AVEC $\neg$OK($L_v$)

FIG.1

FIG.2

FIG.3

FIG.4A

FIG.4B

FIG.4C

FIG.5

FIG.6

FIG.7

660 —⟨ $N_f$ , $N_g$ ⟩

662 —
$$\text{CALCUL DE } N_n$$
$$\{t_0 , t_1 , (a_{i0} , a_{i1} , \ldots a_{ip}) , (a_{s0} , a_{s1} , \ldots a_{sp})\}$$

663 ⟍
DEGRE DE $N_h$ ?

| p = 0 | p = 1 | p = 2 | – – – – – | p > 4 |

664 ⟍

$a_{s0} > 0$
&
$a_{i0} < 0$
— N
0

665 ⟍
ALG 1 — N
0

666 ⟍
ALG 2 — N
0

667 ⟍
RECHERCHE ALGORITHMIQUE DE SOLUTIONS ENTRE $t_0$ ET $t_1$

668 ⟍
MODELE VERIFIE? — N
0

OK(Lv)

⌐OK(Lv)

FIG.9

FIG. 8A

FIG. 8B

FIG. 10